(19)

**Europäisches Patentamt**

**European Patent Office**

**Office européen des brevets**

(11)  **EP 4 481 195 A1**

(12)  **EUROPEAN PATENT APPLICATION**

(43) Date of publication:
**25.12.2024 Bulletin 2024/52**

(21) Application number: **23180031.9**

(22) Date of filing: **19.06.2023**

(51) International Patent Classification (IPC):
*F03D 17/00* ^(2016.01)      *F03D 80/00* ^(2016.01)

(52) Cooperative Patent Classification (CPC):
**F03D 17/029; F03D 17/005; F03D 80/003;**
F05B 2260/76; F05B 2260/80; F05B 2260/83;
F05B 2260/84

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Nordex Energy SE & Co. KG
22419 Hamburg (DE)**

(72) Inventor: **RAVE, Christian
22419 Hamburg (DE)**

(74) Representative: **Epping - Hermann - Fischer
Patentanwaltsgesellschaft mbH
Schloßschmidstraße 5
80639 München (DE)**

(54)  **A METHOD FOR ESTIMATING A HEALTH STATUS OF A PITCH ENERGY STORAGE UNIT OF A WIND TURBINE, AND PITCH CONTROL SYSTEM**

(57)      A method (150) for estimating health status of a pitch energy storage unit (128) of a wind turbine (100) is provided. The method (150) comprises: providing (152) an equivalent circuit model (140), ECM, of the pitch energy storage unit (128), the ECM (140) comprising at least an equivalent series resistor (148) and at least one electrical energy storage element connected between two power terminals (132, 134); repeatedly sampling (156, 158) a voltage u and a corresponding current $i_m$ at the two power terminals (132, 134); determining (160, 162) at least one voltage change and at least one current change for a plurality of voltage samples and corresponding current samples; performing (164) an optimisation procedure based at least on the ECM (140), the plurality of the voltage samples, the determined voltage changes, and the determined current changes to obtain an updated resistance $R_i$ of the equivalent series resistor (148) and at least one updated model parameter of the at least one electrical energy storage element; and estimating (166) at least one status of health, SoC, parameter for the pitch energy storage unit (128) by comparing at least one of the updated resistance $R_i$ and the at least one updated parameter with at least one threshold value.

In addition, a method (300) for charging a pitch energy storage unit (128) of a wind turbine (100), and a pitch control system (120) of a wind turbine (100) are provided.

Fig. 2

**Description**

The invention relates to health status of a pitch energy storage unit of a wind turbine, a method for charging a pitch energy storage unit of a wind turbine, and a pitch control system of a wind turbine.

Wind turbines are widely known from the prior art and are used to convert wind energy into electrical energy. Among others, wind turbines may comprise an energy storage unit to provide all or some parts of the wind turbine with electrical energy, for instance, in case the wind turbine does not generate sufficient energy and is at least temporarily disconnected from an external energy source, such as a power grid, or during situations like grid fault ride-through (FRT) .

In particular, a wind turbine may comprise a so-called pitch energy storage unit, which stores sufficient electrical energy to control a pitch angle of rotor blades of the wind turbine. For example, in case a previously deactivated wind turbine needs to be activated or started, a pitch drive may change the pitch angle of the rotor blades to start the wind turbine. Other operations in which power is provided from the pitch energy storage unit may include (self) testing functions of the wind turbine.

Operational phases, in which power is provided by a pitch energy storage unit, are infrequent and relatively short compared to normal operational phases of a wind turbine, in which the wind turbine provides electrical power to a power grid or is deactivated. However, reliable provision of power is crucial in such operational phases, as this enables, inter alia, the safe activation and deactivation of the wind turbine in exceptional circumstances, such as power grid failures and/or extreme weather situations like gusts.

Like many other components, the performance of pitch energy storage units deteriorates over time. For example, rechargeable batteries used as energy store of a pitch energy storage unit have a limited lifetime in terms of age, charging cycles, etc. However, detecting defective storage devices well in advance is challenging, and often requires additional hardware, computational capabilities, effort and costs for monitoring them. Thus, in practice, the entire pitch energy storage unit or its internal energy storage components are typically replaced at regular service intervals to avoid unintentional outages of and/or damages to the wind turbine due to insufficient energy being stored in the pitch energy storage unit. Replacing a pitch energy storage unit or its internal energy storage components is costly, resource-intensive and may be dangerous. In addition, it typically requires the wind turbine to be deactivated or stopped for service, which therefore, reduces the amount of energy being provided to the power grid.

Accordingly, there is a need to monitor a health or remaining lifetime of a pitch energy storage unit and/or to detect defective storage components comprised therein at an early stage to avoid unintentional outages of and/or damages to the wind turbine and, at the same time, prevent unnecessary service and/or replacement of a pitch energy storage unit.

According to a first aspect of the present disclosure, a method for estimating a health status of a pitch energy storage unit of a wind turbine is provided. The method comprises:

- providing an equivalent circuit model, ECM, of the pitch energy storage unit, the ECM comprising at least an equivalent series resistor and at least one electrical energy storage element connected between two power terminals;
- repeatedly sampling a voltage u and a corresponding current $i_m$ at the two power terminals;
- determining at least one voltage change and at least one current change for a plurality of voltage samples and corresponding current samples;
- performing an optimisation procedure based at least on the ECM, the plurality of the voltage samples, the plurality of the current samples, the determined voltage changes, and the determined current changes to obtain an updated resistance $R_i$ of the equivalent series resistor and updated at least one model parameter of the at least one electrical energy storage element; and
- estimating at least one status of health and parameter for the pitch energy storage unit by comparing at least one of the updated resistance $R_i$ and the updated at least one model parameter with at least one threshold value.

Among others, the inventor has found that a health status of a pitch energy storage unit can be reliably estimated based on the provision of an equivalent circuit model (ECM) and incremental updating of ECM parameters of the pitch energy storage unit. At the same time, the disclosed method is computationally efficient and can be implemented, for example, using an existing controller of the wind turbine, such as a controller of a pitch converter. Thus, health status monitoring and predictive maintenance can be implemented with no or very limited extra effort.

Contrary to known methods, the disclosed method does not require the provision of additional components, such as specialized sensors or measuring devices, the disconnection of the pitch energy storage unit, e.g., to determine an open circuit voltage or resistance of the pitch energy storage unit, or to perform a complete discharge and/or charge cycle of an energy storage element contained therein. Instead, the health status of the pitch energy storage unit can be determined in-situ when the turbine is in operation and, preferably, continuously, so as to minimize and schedule servicing as needed, while preventing unintentional outages.

In at least one implementation, the optimisation procedure is based on a predetermined number of sample tuples, each sample tuple comprising a present voltage sample, a corresponding time derivative $du/dt$ of the voltage $u,$ a present

current sample $i_m$, and a corresponding time derivative $di_m/dt$ of the current $i_m$. The optimisation procedure is performed when a predetermined number of sample tuples has been stored in a buffer storage, so as to ensure sufficient data for a successful optimization.

In at least one implementation, the method further comprises determining whether a present sample tuple meets at least one predetermined filter criterion, in particular, if the present sample tuple differs from all sample tuples contained in the buffer storage. If the at least one predetermined filter criterion is met, adding the present sample tuple to the buffer storage. Otherwise, discarding the present sample tuple. By filtering out unsuitable samples, such as duplicate samples, the quality of the optimization can be improved.

In at least one implementation of the method, the optimization procedure is performed multiple times, and the method further comprises: selecting starting values for a set of optimization parameters optimized by the optimization procedure; determining at least one quality parameter, such as a Residual Square Sum $RSS_{new}$, associated with updated values for the set of optimization parameters obtained after performing the optimisation procedure starting from the starting values; and if the at least one quality parameter $RSS_{new}$ associated with the set of optimization parameters meets at least one quality condition, computing the updated resistance of the equivalent series resistor and the updated at least one model parameter of the at least one electrical energy storage element, and otherwise maintaining a previously computed resistance of the equivalent series resistor and the at least one model parameter of the at least one electrical energy storage element. By using an iterative optimisation method minimizing a quality parameter, the computational method can be reduced in each round. In particular, the parameters of the ECM are only updated when an optimization step has actually resulted in a better approximation of the optimization parameters.

In at least one implementation, the optimisation procedure is performed using a gradient optimizer, wherein the gradient optimizer performs up to $k_{max}$ optimisation steps, with $k_{max} \geq 1$; and the gradient optimizer minimizes the residual square sum (RSS). The use of a gradient optimizer is computationally efficient and approximates the modelling parameters particularly fast.

In at least one implementation, the step of estimating the health status of the pitch energy storage unit comprises comparing the at least one updated parameter of the at least one electrical energy storage element with a nominal parameter value of the at least one electrical energy storage element, in particular, with a predetermined multiple of the nominal parameter value, and/or comparing the updated resistance $R_i$ with a nominal resistance value of the equivalent series resistor, in particular, with a predetermined multiple of the nominal resistance. Note that the term "multiple" may also refer to a fractional multiple in this context, i.e., a case where the respective threshold value is smaller than a given nominal value. By observing characteristic parameters, such as an updated capacity and/or series resistance of a pitch energy storage unit and comparing them with reference values, taken, for example from a data sheet, enables a good estimation of its state of health.

In at least one implementation, the pitch energy storage unit comprises at least one capacitor, in particular an ultra-capacitor, for pitch energy storage, the at least one energy storage element of the ECM is an equivalent capacitor, and the updated parameter corresponds to an updated capacitance C of the equivalent capacitor. Capacitor-based pitch energy storage units have many advantages, including a higher number of charging cycles compared with rechargeable batteries, and can be modelled based on their capacity and series resistance using the disclosed method.

In at least one implementation, the method further comprises, if the health status indicates that the pitch energy storage unit is at or near its begin-of-life, BoL, then charging the capacitor to a first charging voltage sufficient to provide a predetermined amount of electrical power and/or energy. If the health status indicates that the pitch energy storage unit is at or near its end-of-life, EoL, charging the capacitor to a second charging voltage sufficient to provide the predetermined amount of electrical power and/or energy, wherein the second charging voltage exceeds the first charging voltage. Such an adaptive charging model based on a current health status will extend the service life of capacitors.

In at least one implementation, the health status indicates an estimated capacitance C of the capacitor, and a charging voltage for the capacitor is increased from the first charging voltage to the second charging voltage based on the estimated capacitance C, in particular in an anti-proportional ratio. Such an approach ensures optimal charging voltages in all situations.

According to a second aspect of the disclosure, a pitch control system for a wind turbine is disclosed. The wind turbine comprises an energy storage unit and a converter circuit, in particular a pitch energy storage unit and a pitch converter. The energy storage unit comprises at least one energy storage device and has at least two power terminals for receiving or providing electrical energy. The converter circuit is connected via the at least two power terminals to the energy storage unit to selectively charge or discharge the at least one storage device of the energy storage unit. The pitch control system further comprises at least one controller, in particular a controller of the converter circuit, the at least one controller being configured to implement a method according to the first aspect or any of its implementations.

Further advantages, features and further developments are set out by the following exemplary embodiments which are explained in conjunction with the figures. The same or similar elements or elements acting in the same way are provided with the same reference numerals in the figures, wherein:

Figure 1 shows a schematic representation of a wind turbine.

Figure 2 shows a schematic representation of a pitch control system.

Figures 3A to 3C show exemplary equivalent circuit models of energy storage units.

Figure 4 shows steps of a method for determining a health status of an energy storage unit.

Figure 5 shows steps of one cycle of a method for estimating a health status of a pitch energy storage unit based on the equivalent circuit model of Figure 3A.

Figure 6 shows relevant parameter values determined from the method for estimating a health status of Figure 5.

Figure 7 shows a flowchart of an adaptive charging method.

Figure 8 shows the influence of temperature on capacitance and series equivalence of a capacitor.

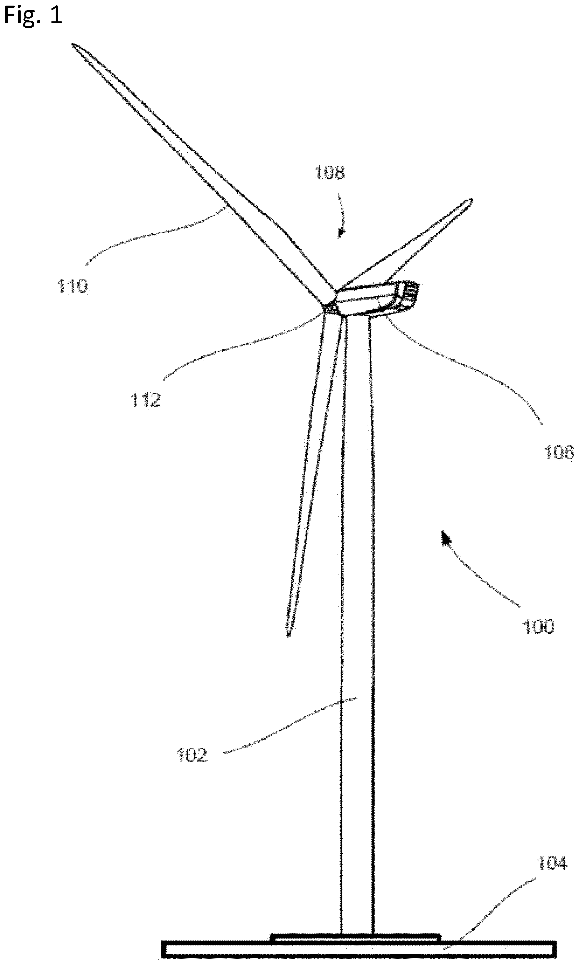

Figure 1 shows a schematic view of a wind turbine 100, which comprises a tower 102. The tower 102 is fixed to the ground by means of a foundation 104. At one end of the tower 102 opposite to the ground a nacelle 106 is rotatably mounted. The nacelle 106, for example, comprises a generator which is coupled to a rotor 108 via a rotor shaft (not shown). The rotor 108 comprises one or more (wind turbine) rotor blades 110, which are movably arranged on a rotor hub 112.
During operation, the rotor 108 is set in rotation by an air flow, for example wind. This rotational movement is transmitted to the generator via the rotor shaft, with or without a gearbox. The generator converts the mechanical energy of the rotor 108 into electrical energy.
To control the rotational speed of the rotor, the rotor blades 110 can be adjusted by rotating them along the longitudinal axis. This rotation is performed by a pitch control system, comprising one or more pitch drives.

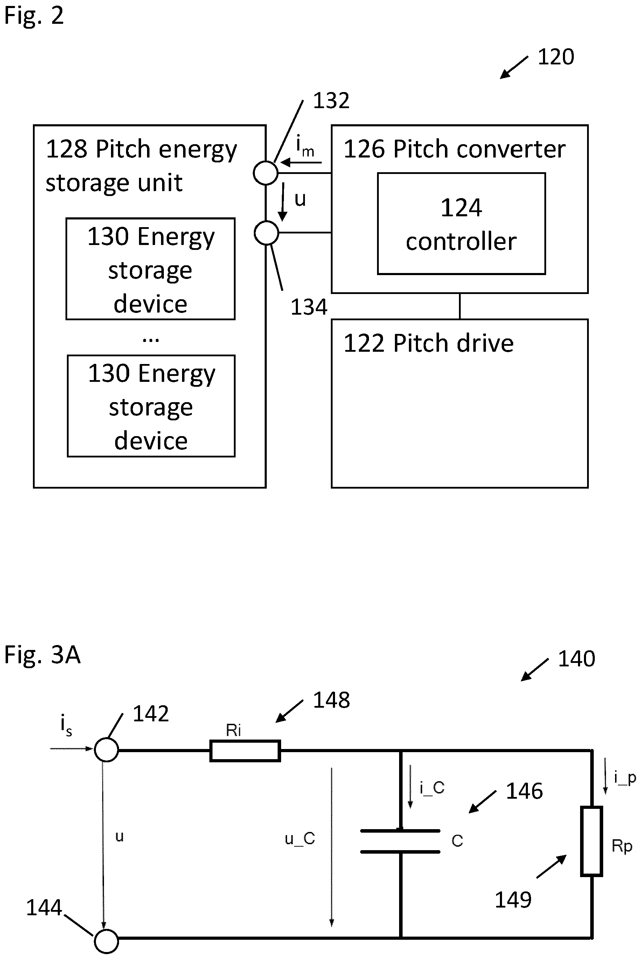

Figure 2 shows, in a schematic manner, a pitch control system 120. The pitch control system 120 comprises one or more pitch drives 122, a pitch controller 124, a pitch converter 126 and a pitch energy storage unit 128.
Each pitch drive 122 may comprise an electrical motor (not shown), such as a servo motor, and a transmission system (not shown) for coupling the electrical motor to at least one of the rotor blades 110. The pitch drives 122 are controlled by the pitch controller 124. The pitch controller 124 may be a separate component or may be an internal controller of another component. It usually comprises or has access to the measurement circuitry for measuring voltage and current provided by the pitch energy storage unit 128. Moreover, it usually controls a charging or discharging current of the pitch energy storage unit 128. In the depicted embodiment, the pitch controller 124 forms part of the pitch converter 126. However, this is not limited by the present disclosure. Electrical energy required for the operation of the pitch drives 122 and the pitch controller 124 is provided by the pitch converter 126.
In normal operation, the electrical energy required for the pitch control system 120 may by derived from the generator coupled to the rotor 108. In particular, the electrical energy generated by the generator is supplied and stored in the grid, and the pitch control system 120 may draw power from the grid to operate. However, in case the rotor 108 is not moving or the generator does not provide sufficient electrical energy, all or parts of the electrical energy for the operation of the pitch control system 120 may be provided by other power sources, including the pitch energy storage unit 128. This is important, as the pitch control system is also important for braking the rotor 108, e.g., in case of strong winds or emergency shut-down of the turbine. In this regard, the pitch converter 126 and pitch energy storage unit 128 effectively provide an uninterruptable power supply (UPS) functionality, to enable pitch control even in the absence of any wind, or during a power grid failure, or failure of other components of the wind turbine 100, or during circumstances like grid fault ride-through (FRT) characterized by low or high grid voltages.
The pitch converter 126 is also responsible for charging one or more energy storage devices 130, such as rechargeable batteries or capacitors, of the pitch energy storage unit 128. In an embodiment of the disclosure, the capacitor may be categorized as an electric double-layer capacitor, ultra-capacitor (UC) or a super-capacitor (SC) based on their storage capacities and other characteristics. For example, UCs or SCs are high-capacity capacitors with high energy density than the conventional electrolytic capacitors and having a tolerance for charge-discharge cycles much larger than rechargeable batteries. However, for the sake of simplicity, the term capacitor has been used throughout the description which may be interchangeably referred to as an ultra-capacitor or a super-capacitor.
Charging is typically performed in case sufficient electrical energy for charging is available, e.g., from the generator or an electricity grid, to which the wind turbine 100 is connected during normal operating states. Preferably, the pitch energy storage unit 128 should always store sufficient electrical energy to enable the pitch control system 120 to at least brake or stop the wind turbine 100 to a standstill in the most adverse conditions. Preferably, it should also hold enough energy to restart the wind turbine when normal conditions are restored.

Due to the uncertainty of such emergency operations, the pitch energy storage unit 128 is used infrequently and in a non-predictable manner. However, if it is relied on, it may need to provide a relatively high amount of electrical power and corresponding high electrical current in a relatively short duration of time for pitching, particularly with a high torque. Thus, energy storage devices 130 with a relatively high storage and discharge capacity are used in pitch energy storage unit 128. Moreover, such energy storage devices 130 need to be replaced before their capacity becomes insufficient to provide the required amount of electrical energy, e.g., due to thermal or electrical stresses leading to deterioration of health.

Determining the actual storage capacity and/or momentary electrical charge or other characteristics of the one or more energy storage devices 130 encapsulated in the pitch energy storage unit 128 is a difficult task. For example, electrolytes of energy storage devices 130 like batteries may be affected in different ways by environmental stress. Moreover, the information about the internal state of the one or more energy storage devices 130 constituting the pitch energy storage unit 128 available to the pitch controller 124 may be limited or not reliable enough. Thus, in practice, energy storage devices are often charged using a maximum nominal charging voltage, current or time at regular intervals or whenever they have been used, and are replaced at regular intervals, e.g., before their shortest possible service life or when they approach end-of-life.

According to the present disclosure, an improved approach to monitoring the health and charging of a pitch energy storage unit is provided.

As can be seen in Figure 2, the pitch converter 126 is connected by at least two terminals 132 and 134, typically a positive and a negative direct current (DC) terminal, to the pitch energy storage unit 128. The voltage between these two terminals 132 and 134 and a current flowing through each one of these terminals 132 and 134 provides some information about the charging and discharging characteristics of the energy storage devices 130. These parameters may be observed from the outside, for example using corresponding measurement circuitry of the pitch converter 126. However, this information alone is insufficient to directly estimate the remaining capacity of the energy storage unit 128.

To better assess an actual storage capacity, the disclosed system makes use of an equivalent circuit model (ECM) of the energy storage unit 128. Figure 3A shows an exemplary ECM 140 for an energy storage unit 128 comprising a plurality of capacitors (sometimes also referred to as super-capacitors or ultra-capacitors) as energy storage devices 130. For example, the energy storage unit 128 may comprise multiple capacitors connected in series and/or in parallel to form multiple storage cells or a capacitor bank. Optionally, a balancing network having one or more circuit elements may be connected in parallel to balance the power provided by each storage cell.

Nonetheless, the ECM 140 shown in Figure 3A comprises only a single equivalent capacitor 146, which represents the combined capacitance C of all physical capacitors. Moreover, a single equivalent series resistor 148 with resistance $R_i$ and an optional equivalent parallel resistor 149 with resistance $R_p$ are shown, which model the internal resistance and losses of the energy storage unit 128, respectively. The equivalent series resistance $R_i$ corresponds to the internal resistance of the storage cells, all connections, lines, wires and so on. The equivalent parallel resistance $R_p$ corresponds to leakage currents of the capacitors themselves or losses caused by other components, such as an internal, passive balancing network.

Note that the nodes 142 and 144 shown on the left of the ECM 140 correspond to the terminals 132 and 134 of the energy storage unit 128. The voltage $u$ between them and the current $i_m$ measured through, for example, the first terminal 132, can be observed from the outside. It is more difficult to obtain real-time values for the model parameters, in particular the equivalent capacitance $C$, the equivalent series resistance $R_i$ and the equivalent parallel resistance $R_p$. Similarly, one cannot directly observe the modelled internal voltages and currents, like the voltage $u\_C$ across the capacitor 146 as well as the currents $i\_C$ and $i\_p$ through the capacitor 146 and the parallel resistor 149, respectively. While these parameters cannot be directly observed, they can be derived from the ECM 140 indirectly, as further detailed below.

In the disclosed embodiment, an estimator is employed to determine at least the capacitance $C$ and series resistances $R_i$ based on multiple samples of the voltage and the current measured at the terminal 132 and 134. Optionally, the estimator may also be used to determine the parallel resistance $R_p$ as further detailed below. The estimator uses an optimizer to match the voltage u and current $i_s$ of the ECM 140 to those measured at the terminals 132 and 134 of the energy storage unit 128 to determine real-time values of the parameters, like capacitance and internal resistance. The model parameters of the ECM 140 are tuned by the optimizer. The difference between the measured and calculated values provides a figure of merit, which serves a measure of the quality of the estimation.

Attention is drawn to the fact that in the targeted application, the current $i\_p$, which represents the leakage current of the capacitor 146 and the current through the balancing network, may be insignificant compared to the total current $i$. Thus, the proposed method may be simplified and more stable when the value of the parallel resistance $R_p$ is set to a constant, or is omitted completely, and only the model parameters $R_i$ and C are subject to the optimization. However, as a more general case, in the following the optimization of all three model parameters of the ESM 140 of Figure 3A are described.

It is also possible establish a similar ECM and formulate similar differential equation(s) for solving the voltage parameter (instead of the current parameter as indicated in the embodiment described herein above and below in detail).

In that case, a measured voltage $u_m$ and a calculated voltage $u_s$ to be determined from the ECM are considered.

Definitions and Equations:

The current $i_s$ through the measurement node 142 calculated from the ECM 140 is characterized by the differential equation:

$$i_s := C/(1 + R_i/R_p)\, du/dt - CR_i(1 + R_i/R_p)\, di_m/dt + 1/(R_p + R_i)\, u \qquad (1)$$

Where $C$, $R_i$, $R_p$, and u have the regular meanings as described above, $dx/dt$ represents rate of change or time derivative of parameter $x$, which in this case are applied to the measured voltage u and the measured current $i_m$. On the other hand, the current measured at the corresponding first terminal 132 measured is denoted as $i_m$ herein above and below. The voltage u between the measurement node 142 and the reference node 144 corresponds to the voltage measured across the two terminals 132 and 134.

For each optimization interval, the estimator collects a measurement sample consisting of four values, i.e., a rate of a voltage change $x1$, a rate of a current change $x2$, a terminal voltage $x3$ and a current $i_m$ measured across the terminals:

$$x1 := \frac{du}{dt} \qquad\qquad x2 := \frac{di_m}{dt} \qquad\qquad x3 := u \qquad (2)$$

The time derivatives $du/dt$ and $di_m/dt$ are calculated from the measured values for u and $i_m$, for example by comparing two subsequent measurements of a time-series of measurements performed by the pitch converter 130 or by any other means. The resulting samples, i.e., the quadruples ($x1$, $x2$, $x3$, $i_m$) are then stored, for example, in a ring buffer of size N.

To simplify the equations, the following optimization parameters are defined:

$$a1 := C/\left(1 + \frac{R_i}{R_p}\right) \qquad a2 := -CR_i\left(1 + \frac{R_i}{R_p}\right) \qquad a3 := 1/(R_p + R_i) \qquad (3)$$

Each optimization parameter $a1$, $a2$ and $a3$ may be a characteristic or a function of one or more of C, $R_i$ and $R_p$. Using relations (2) and (3), equation (1) can be simplified as:

$$i_s = a1\, x1 + a2\, x2 + a3\, x3$$

Thus, the error of $n^{th}$ sample, defined as the difference between the calculated current $i_{s,n}$ and the measured current $i_{m,n}$ is

$$r_n = i_{s,n} - i_{m,n} = [(a1\, x1_n + a2\, x2_n + a3\, x3_n) - i_{m,n}]$$

The residual square sum (RSS) for all samples is

$$RSS = \sum_{n=1}^{N}(i_s(a1, a2, a3, x1_n, x2_n, x3_n) - i_{m,n})^2$$

$$= (i_{s,1} - i_{m,1})^2 + (i_{s,2} - i_{m,2})^2 + \cdots\ldots\ldots + (i_{s,n} - i_{m,n})^2$$

Or, in an alternative notation, $RSS = \|A\,a - I_m\|^2$, where $A$ is a matrix comprising a subset of the first three entries ($x1$, $x2$, $x3$) of each of the $N$ samples, $a$ is a vector of the optimization parameters ($a1$, $a2$, $a3$), and $I_m$ is a vector of $N$ comprising the last entry of each of the N samples corresponding to the measured currents $i_m$.

The goal for the optimizer is to minimize RSS by tuning the optimization parameters $a1$, $a2$, and $a3$. This results in an approximation of the calculated current $i_s$ to the measured current $i_m$. From the optimization parameters $a1$, $a2$, and $a3$, the model parameters $C$, $R_i$ and $R_p$ of the equivalent circuit 140 can be calculated based on the equations above.

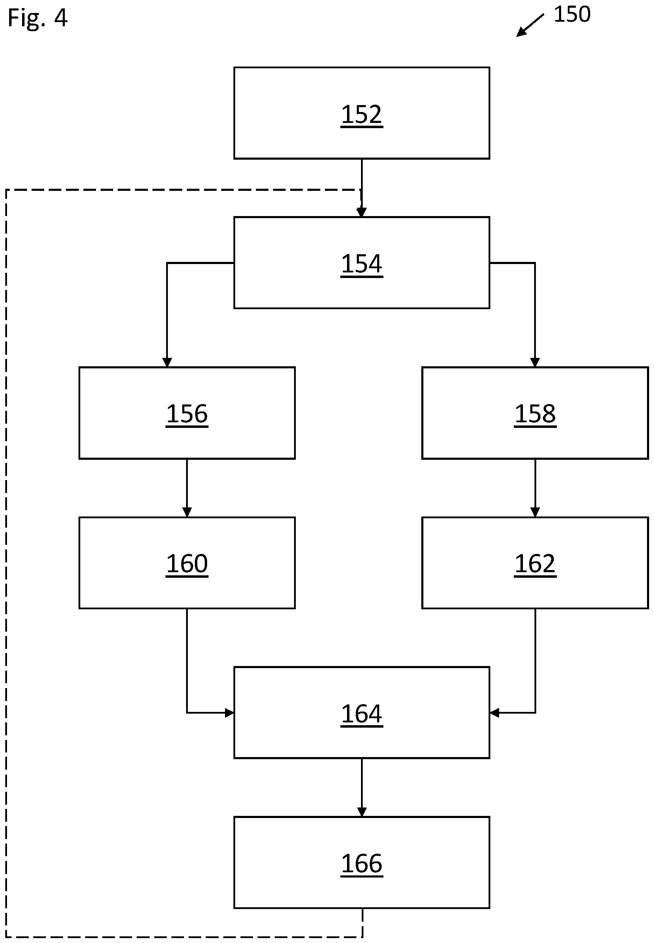

Figure 4 shows, in more general terms, steps of a method 150 for determining a health status of an energy storage unit. Note that the method 150 may be performed during normal operation of the wind turbine 100, i.e., while the rotor 108 is turning and the generator provides electrical energy to an electricity grid.

In method step 152, a suitable ECM is provided. For example, the ECM 140 may be provided for estimating a current capacitance or health state of an energy storage unit 128 comprising a plurality of capacitors as energy storage devices 130. Alternatively, an ECM based on a different type of energy storage device may be used, such as an ECM comprising a voltage source and a shunt resistor, which represents an energy storage unit 128 comprising one or more rechargeable batteries.

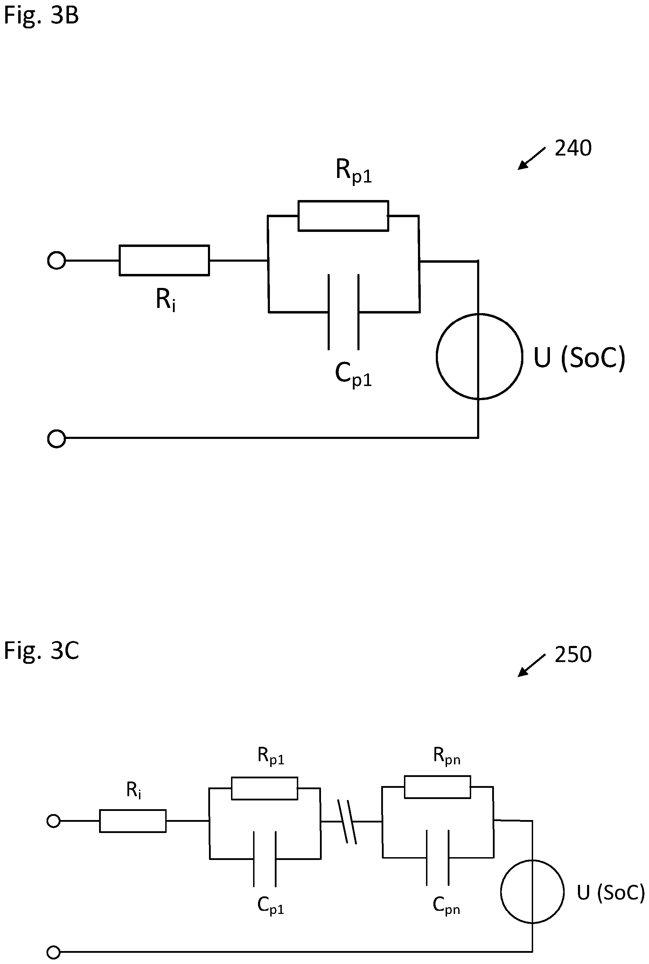

Figure 3B shows a corresponding first order ECM 240 for a battery based energy storage unit 128, and Figure 3C shows a corresponding $n^{th}$ order ECM 250 for a battery based energy storage unit 128. Corresponding equations for the ECMs 240 and 250 can be derived based on similar observations as detailed above with respect to the ECM 140. In the ECM 240 and 250, the voltage $U(SoC)$ is a function of the state of charge (SoC) of the battery based energy storage unit 128.

In method step 154, initial values are provided for the estimator. For example, known reference values, for example, the values defined in the specification of the original equipment manufacturer (OEM), may be provided for a new energy storage unit 128. Alternatively, the initial values may be calculated based on a known physical configuration and the technical specification of used components taken from corresponding data sheets.

In method steps 156 and 158, a sampling component measures the voltage $u$ and the current $i_m$ across/at the terminals 132 and 134. Steps 156 and 158 may be performed at regular intervals, e.g., once per second or minute, or may be triggered by specific events, i.e., the activation of a service routine, a detection of a charge or discharge event, or a combination of both.

As detailed below, method steps 156 and 158 need to be performed repeatedly before the optimization is performed for the first time. In at least some embodiments, steps 156 and 158 are performed throughout the operation of the wind turbine 100.

In subsequent method steps 160 and 162, the sampling component calculates the time derivatives $du/dt$ and $di_m/dt$, respectively, with respect to the previously taken sample. Moreover, the sampling component may weigh and/or select samples as further detailed below. For example, only samples that fulfill certain criteria, such as a predefined quality of the measurement, proximity to a relevant operating point, and/or uniqueness, are considered and placed, for example, into a ring buffer.

When new samples are added in further iterations of the method steps 156 to 162, and in case of a limited data structure such as the ring buffer, the oldest sample may be previously removed or overwritten by the new sample.

Once a sufficient number of samples is available, for example when the ring buffer is full, the optimizer can start working as illustrated by method step 164. The optimizer provides as its output updated values of the model parameters, such as the equivalent capacitance $C$, the equivalent series resistance $R_i$ and, optionally, the equivalent parallel resistance $R_p$ of the ECM 140.

The optimizer may be implemented as a gradient optimizer as further detailed below. This is beneficial to minimize the computational effort. In each time step, the optimizer takes only a limited number of optimization steps. While it will take some time to find a suitable solution, this reduces the computational effort and provides a filtering effect against measurement and numerical noise.

Alternatively, for example, a more powerful controller or a general-purpose processor may be available for monitoring, and/or other optimizers or optimization methods known to the skilled person may be employed. Such optimization methods may comprise, among others, simulated annealing, particle swarm optimization, or the use of generic algorithms. While the computational effort of such optimization methods is much higher as in the case of a gradient optimizer, they may be beneficial, for example, to avoid local optima. Such optimization methods may also be useful for optimizing parameters of a more complex ECM, such as a potentially higher order model of a battery based pitch storage unit.

In method step 166, a health status for the pitch storage unit 128 is computed and, optionally, output. This is based on a comparison of the model parameters computed in method step 164 with known reference values at the end of the life of a given pitch storage unit 128. Such a health status value may represent a remaining lifetime as a percentage value and may be used to plan servicing or replacement of the pitch storage unit 128. It may also be used for operation of the pitch control system, such as implementing an adaptive charging of the pitch storage unit 128 as further detailed below.

Attention is drawn to the fact that the described method 150 may be performed in a continuous manner throughout the operation of the wind turbine 100. In that case, method steps 154 to 166 may be repeated in a loop-like structure. Note that in this case, the output model parameters computed in method step 164 may be used as initial ECM parameter values for method step 154 in the next iteration.

Attention is drawn to the fact that the physical parameters of the pitch storage unit 128 corresponding to the model parameters of the ECM typically change much slower than a timeframe, in which the optimizer converges. Thus, after the optimizer has reached a minimum in one cycle or iteration of the optimization procedure, it can follow the change of the physical parameters easily.

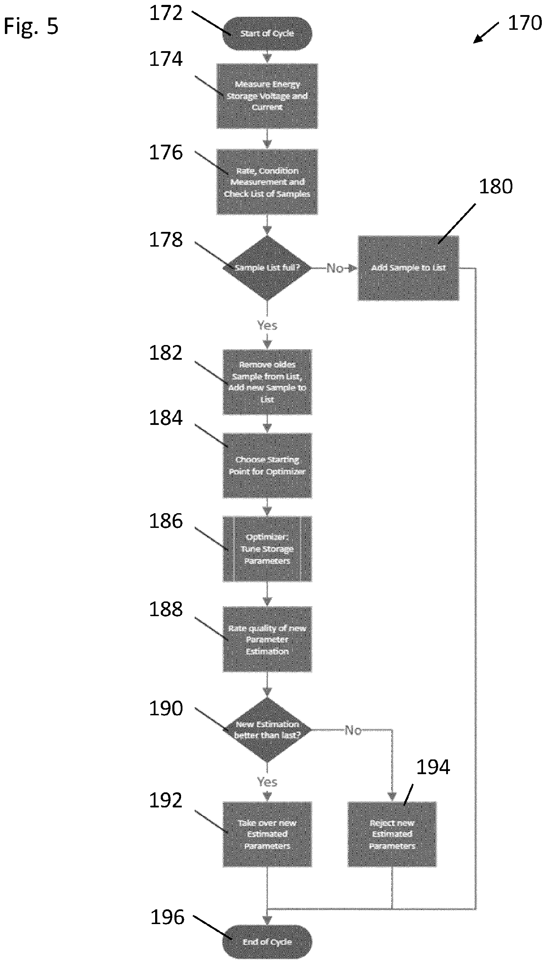

Figure 5 shows specific implementation details of one cycle of a method 170 for estimating a health status of a pitch energy storage unit based on the ECM 140 of Figure 3A. As before, the method 170 may be performed during normal operation of the wind turbine 100.

The estimation cycle starts at step 172. For example, an update of the health status can be triggered at a regular interval or on occurrence of a specific event. If the method is triggered for the first time, preconfigured values for $C$, $R_i$, $R_p$ are loaded into the estimator. The preconfigured values may be taken from the component specification as an initial guess. Otherwise, the estimator loads or maintains the values for the model parameters $C$, $R_i$, $R_p$ from a previous estimation cycle.

In a step 174, the voltage u and current $i_m$ at the terminals 132 and 134 of the pitch energy storage unit 128 are measured. Using the ECM 140 definitions and equations from above, the measured voltage can be used directly as third sample value $x_3 = u$. Equally, the first and second sample values are determined by computing the voltage and current change $x_1 = du/dt$ and $x_2 = di_m/dt$, respectively.

In case the estimation cycle is performed at regular, relative short intervals, for example every second, the time derivatives $du/dt$ and $di_m/dt$ can be approximated by simply computing the differences between the presently measured values for $u_t$ and $i_{m,t}$ and their respective predecessors $u_{t-1}$ and $i_{m,t-1}$ from the last estimation cycle, i.e. $x_1 = du/dt = (u_t - u_{t-1})/\Delta T$ and $x_2 = di_m/dt = (i_{m,t} - i_{m,t-1})/\Delta T$, where $\Delta T$ is the sampling interval between samples taken at time $t-1$ and $t$. In case the cycle is performed at irregular and/or longer intervals, multiple measurements should be taken during step 174 and used to determine the present rates of change for the voltage and current. In other embodiments, numerical schemes for equal and unequal time intervals (e.g. time steps) may be applied to determine rate of change of voltage and current corresponding to different time instants.

In step 176, the newly acquired samples are conditioned. This may comprise one or more of the following options.

As a first option, depending on the sampling frequency, filtering may be applied to smooth sampling errors.

As a second option, conditioning is implemented, at least in part, by weighting of the individual sample values, i.e. quadruples $(x1, x2, x3, i_m)$. For example, as described above, the influence of the equivalent parallel resistance $R_p$ on the optimization result may be typically small. To make it relevant for the optimization, the possible error is increased by a high weighting factor. Also, the influence of samples with a poor measurement quality can be decreased with a low weighting factor. In the described embodiment, samples with large $du/dt$ or $di_m/dt$ get a lower weighting factor. This is partly to reduce the influence of noise, partly because the capacity of the capacitors is strongly frequency dependent.

As a third option, sample tuples $(x1, x2, x3, i_m)$ that are already contained in an identical form or within a predefined tolerance interval of an existing sample in the ring buffer, may be rejected, i.e., not entered into the ring buffer a second time.

In step 178, the method checks whether a list or set of samples contains sufficient sample tuples to perform the optimization procedure. In the described embodiment, a fixed number of samples is used by the optimization procedure, which are stored in a ring buffer of a corresponding size. In this case, in step 178 it is verified whether all storage locations of the ring buffer are filled with a valid sample.

If the list of samples is still incomplete, i.e. if there are still unused spaces in the ring buffer, in step 180, the newly acquired sample is added to the stored set of samples. Thereafter, the present estimation cycle ends immediately, as there is not enough data available for optimization yet.

Otherwise, i.e., if a sufficient number of samples has been stored, the method proceeds in step 182 with removing the oldest previously stored sample from the list of samples. The present sample is then stored at the end of the list. In case of a ring-buffer, this may be achieved by simply overwriting a corresponding storage location based on a cyclic indexing scheme.

In step 184, a starting point is chosen for the optimizer. In the specific implementation, to combine computational efficiency as well as a stable output of the optimizer, this step may be performed in one of two possible ways. In particular, at regular intervals, e.g. every $x^{th}$ cycle starting from and including the first time the optimizer is started, an initial parameter set may be used as starting point for the optimization. As detailed above, the initial parameter set may be derived from knowledge of the actual structure of the pitch energy storage unit 128. In addition to characteristic values contained in or derived from the components data sheet, such values may also be updated in accordance with a predicted aging, e.g., of the energy storage devices 130.

Alternatively, e.g., at all other cycles, the parameter obtained from last cycle of the estimation method 170 are used as starting point for a run of the optimizer.

In step 186, the actual optimization takes place.

Note that a gradual optimizer is used, which performs optimization using a discrete number of optimization steps, up to a predefined maximal number of steps, i.e., $k_{max}$.

In mathematical terms, the optimization process can be expressed as follows:

At step number $k$,
Optimization parameters at step $k$: $a^k$

Note that the set of optimization parameters forms a vector *a*, and that $a^k$ refers to the vector with index *k*, starting with *k=1*.

Then, the RSS, *RSS(a^k)*, is computer for step *k*, based on the optimizer "gradient", $d^k$, as follows:

$$d^k = -D^k \nabla RSS(a^k)$$

$$D^k = \begin{pmatrix} \frac{\partial a_1^2}{\partial^2 RSS} & 0 & 0 \\ 0 & \frac{\partial a_2^2}{\partial^2 RSS} & 0 \\ 0 & 0 & \frac{\partial a_3^2}{\partial^2 RSS} \end{pmatrix}$$

$$d^k = -\begin{pmatrix} \frac{\partial a_1^2}{\partial^2 RSS} \frac{\partial RSS}{\partial a_1} \\ \frac{\partial a_2^2}{\partial^2 RSS} \frac{\partial RSS}{\partial a_2} \\ \frac{\partial a_3^2}{\partial^2 RSS} \frac{\partial RSS}{\partial a_3} \end{pmatrix}$$

$$RSS = \sum_{n=1}^{N} \left( a_1 x_{1,n} + a_2 x_{2,n} + a_3 x_{3,n} - i_m \right)^2$$

$$\frac{\partial RSS}{\partial a_1} = 2 \sum_{n=1}^{N} x_{1,n} \left( a_1 x_{1,n} + a_2 x_{2,n} + a_3 x_{3,n} - i_m \right)$$

$$\frac{\partial^2 RSS}{\partial a_1^2} = 2 \sum_{n=1}^{N} x_{1,n}^2$$

The optimizer uses a defined step length $\rho$ to perform the next optimizer step with $a^{k+1} = a^k + \rho \, d^k$.

The step length $\rho$ can either be fixed, or optimized by itself using a back tracking approach. In the described implementation, a fixed step length $\rho$ is used.

Note that step 186 may be performed in a repetitive manner, e.g. forms an inner loop with the outer loop corresponding to repeated execution of the estimation method 170 as shown in Figure 5. As long as the present step number is smaller than the maximum number of steps, i.e. $k \leq k_{max}$, the optimizer continues with the next optimization step in sub-procedure 186. Otherwise, sub-procedure 186 terminates, and the current parameter values are taken as intermediate output for the present cycle of the estimation method 170.

Attention is drawn to the fact, that only a few or even a single optimization step may be performed in each estimation cycle of the disclosed method 170. For example, in the described implementation $k_{max} = 1$ is used, meaning that only single optimization step is performed during each execution of method step 186. When there is only one step, the optimizer effectively runs over several cycles of the estimation method 170.

In step 188, a quality parameter for the new parameter estimation is determined. In the described embodiment, the RSS of the last optimization step is used as quality parameter, e.g. a figure of merit, and stored in a separate variable, i.e. *RSS_new = RSS(a^k)*.

In step 190, the quality parameter *RSS_new* determined in step 188 of the present cycle is compared with a quality parameter *RSS_last* determined in step 188 of a previous estimation cycle of method 170.

If it is determined that the newly computed set of optimization parameters *a1, a2* and *a3* from the optimizer is better than the previously used set of optimization parameters, i.e., if *RSS_new < RSS_last,* the model parameters $C$, $R_i$ and $R_p$ of the ECM 140 are newly computed based on the above equations.

In the described implementation, an additional plausibility or sanity check on the newly calculated values for $C$, $R_i$ and $R_p$ is performed. In particular, it can be verified if the newly calculated values for $C$, $R_i$ and $R_p$ fall into respective, for example preconfigured, ranges of reasonable parameter values.

If it is determined in step 190 that the new parameter values are better and plausible, in step 192, the present optimization parameters a, e.g., the vector *(a1, a2, a3),* and model parameters, e.g. $C$, $R_i$ and $R_p$, are overwritten with the last set of corresponding parameters obtained in steps 186 and 190, respectively.

Optionally, at this stage, an appropriate filter may be applied prior to the updating of the stored parameter values, for example to prevent sudden changes in the respective parameter values.

Otherwise, if it is determined that the last set of parameters are not better than the previously stored set of parameters, the newly computed parameters are rejected in step 194.

Either way, the cycle of the estimation method ends in step 196. If necessary, the present state of the estimator and/or optimizer is stored at this stage and used as initial values in the next estimation cycle.

At this stage, the current model parameters for $C$, $R_i$ and $R_p$ may be output or logged for use by other components, such as the adaptive charging method described later. Alternatively, or in addition, an aggregate health status may be computed based on one or more threshold values. Such an aggregated health status may be used to schedule and implement predictive maintenance. Note that in general, the capacitance of a capacitor will decrease over its lifetime, while its series resistance will increase. Only if the corresponding model parameters output by the estimator lie outside an allowed range for safe operation of the wind turbine 100, maintenance is required.

For example, beginning-of-life (BoL) and end-of-life (EoL) thresholds may be provided based on nominal values provided in the component's data sheet. In particular, a BoL capacitance $C_{BoL}$ may be provided by the manufacturer of a capacitor serving as the energy storage device 130. Then, a corresponding EoL capacitance $C_{EoL}$ may be computed, for example, as 80% of the $C_{BoL}$ value, i.e., $C_{EoL} = 0.8 \cdot C_{BoL}$. A current health status of the energy storage device 130 may be expressed relative to these values as a percentage value. Note that in practice, a capacitor may initially have a capacitance even higher than a nominal capacitance indicated in its datasheet. In this case, the health status of the capacitor would be more than 100%. Inversely, if it is not possible to replace the capacitor in good time, its actual capacitance may drop to below $C_{EoL}$, which would result in a negative health status value. Similar definition and observation also apply with regard to one or more internal resistance values, which can be compared with the series resistance $R_i$ or parallel resistance $R_p$. For example, a series resistance $R_i$ of 200% of the initial series resistance $R_{BoL}$ of a capacitor may mark its end-of-life value $R_{EoL}$, i.e., $R_{EoL} = 2 \cdot R_{BoL}$.

In the described embodiment, the lower of the two percentage values is taken as the total health status. As soon as one of the two values approaches, reaches or even falls below the respective EoL value, predicted maintenance is scheduled, at which the entire pitch energy storage unit 128 or its internal energy storage device 130 is replaced. Note that a sudden drop below or above the respective threshold may also allow to identify defective energy storage devices 130.

To make sure that the estimator is provided regularly with new, relevant samples, a controller executing the method 170, e.g., the pitch controller 124, can request a small charge or discharge of the pitch energy storage unit 130. The frequency of these tests may depend on the quality of the last estimation, which is measured by the RSS as detailed above.

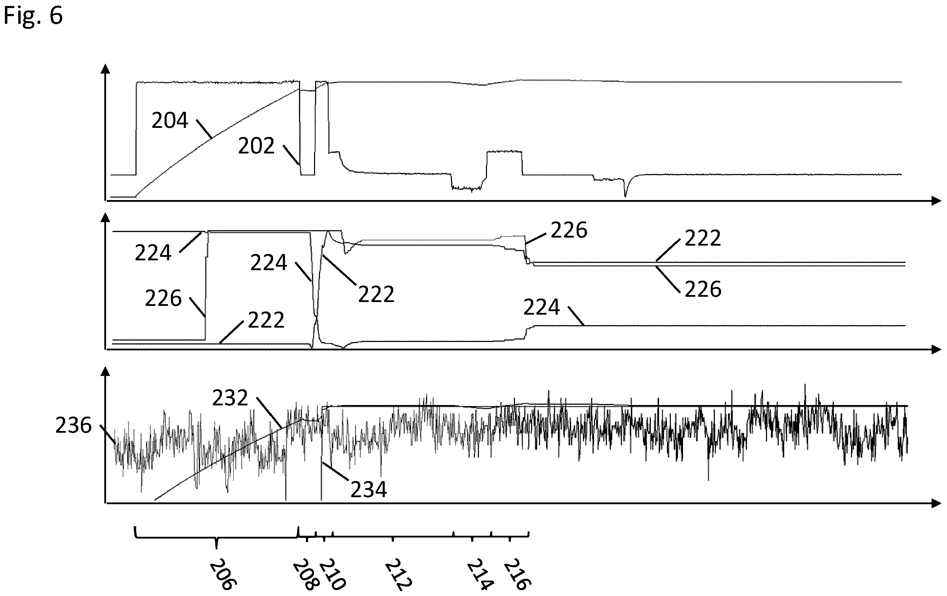

Figure 6 shows relevant parameter values determined by a continuously running estimator based on the ECM 140 shown in Figure 3 and the method 170 as described above with respect to Figure 5.

In particular, the upper part of Figure 6 shows a first graph 202 of the current $i_m$ and a second chart 204 of the voltage $u$ measured at the terminals 132 and 134 of the pitch energy storage unit 128 over time.

In the present example, the pitch energy storage unit 128 comprises one or several capacitors, which are initially completely discharged, e.g. on their first connection to the pitch converter 126. Accordingly, the voltage initially increased from zero to a predetermined first target voltage. During this first phase 206, the charging current is more or less constant.

In a second phase 208, the charging current drops to zero, e.g. due to a deliberate interruption of the charging cycle or due to an accidental grid failure. Note that the pitch drive 122 is not activated in this phase. Accordingly, the voltage $u$ may only drop slowly and insignificantly at this phase, e.g., to a self-discharging of the capacitors or due to losses caused by a balancing network.

In a third phase 210, the charging process continues with the same, more or less constant charging current, until the pitch energy storage unit 128 has reached a second target voltage, , at which the capacitors are essentially fully charged.

Accordingly, the charging current $i$ drops back to and essentially remains at zero in a subsequent fourth phase 212.

Note that at this stage, the state of health of the energy storage unit 128 may not be known yet, as the estimator may not yet have obtained sufficient data for optimizing the ECM 140. Accordingly, the second target voltage may represent a default value for charging the energy storage unit 128.

In a fifth phase 214, the current i becomes negative, indicative of a discharge operation. This may be caused by the operation of the pitch drive 122, while no or only an insufficient amount of electrical energy is available from the generator or a supply grid. It may also be used to improve the results provided by the estimation method 170, for example by deliberately discharging the capacitor in a controlled manner. Accordingly, the voltage u drops during the fifth stage 214.

In a sixth phase 216, the pitch drive 122 is deactivated and/or the controlled discharging stops, and the pitch energy storage unit 128 is charged again. Accordingly, the charging current i becomes positive and the voltage u increases again, this time to a third target voltage.

Note that at this stage, the state of health of the energy storage unit 128 is already known, as the estimator has now obtained sufficient data for optimizing the ECM 140. Accordingly, the third target voltage may represent an optimized target voltage for charging the energy storage unit 128 based on its current state of health.

The middle part of Figure 6 shows a third graph 222 of the estimated capacity C, a fourth graph 224 of the equivalent series resistance Ri, and a fifth graph 222 of the root mean square (RMS) of the quality parameter of the ECM 140, e.g., the square root of the RSS value, over time. Note that the RMS value stands for the estimation errors in terms of an error current.

It can be seen that the estimator initially used a first capacitance estimate, which may be taken directly from a data sheet of the capacitors included in the pitch energy storage unit 128. However, during optimization, this value is increased to a second capacitance value during the second phase 208. In later phases, the capacitance is approximated further, and eventually sinks to a third capacitance value. Similar changes can be observed for the fourth graph 224 and fifth graph 226, which show the gradual approximation of the respective model parameters as the estimator processes further samples.

The lower part of Figure 6 shows a sixth graph 232 of the estimated state of charging (SoC) of the pitch energy storage unit 128 indicated as a percentage value, a seventh graph 234 of its state of health (SoH) also indicated as a percentage value, and an eighth graph 236 of the internal temperature of the capacitor over time. Note that the SoC corresponds to the ratio of the current voltage with respect to the target voltage, i.e. SoC = Current Voltage/ Target Voltage.

A manual comparison with respective parameters determined by direct measurements or retrieved over corresponding field busses of the internal components of the pitch energy storage unit 128 showed a good match of the estimated model parameter values, at least from the fourth phase 212 onwards, e.g. after one complete charging operation of the pitch energy storage unit 128.

As discussed above, knowing the SoH of the pitch energy storage unit 128 enables, among others, to perform system maintenance, including replacement of the pitch energy storage unit 128 or of the energy storage device(s) 130 contained therein, according to their specific requirements, for example, just-in-time. Thus, early replacement of energy storage device(s) that have been operated, for example, in less extreme conditions, have been used less than anticipated or simply have a better quality than indicated in their datasheet, can be retired later in their life. Conversely, storage device(s) that have been operated, for example, in very demanding conditions, have been used more than anticipated or simply have a lower quality than indicated in their datasheet, can be replaced earlier to avoid equipment failures.

Moreover, according to another aspect of the disclosure, a good knowledge of the actual SoH of the pitch energy storage unit 128 or its internal components may also be used to actually prolong their service life by implementing an adaptive charging scheme as further detailed below.

Depending on the type of energy storage device 130 used, adapting a charging procedure and/or parameters, may extend its lifetime. In the following, an adaptive charging method for a capacitor-based pitch energy storage unit 128 is described as an example. However, similar approaches may also be applicable to other types of energy storage device 130, such as rechargeable batteries.

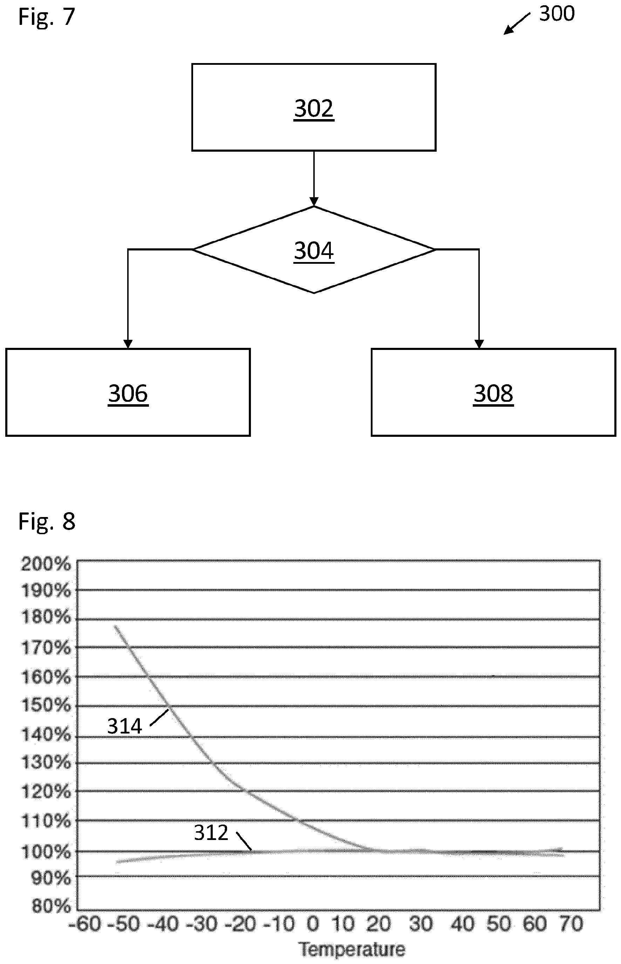

Figure 7 shows a flow chart of an adaptive charging method 300. The method 300 is applicable, for example, to the wind turbine 100 described above with respect to Figure 1, and the pitch control system 120 described above with respect to Figure 2.

In step 302, the current SoH of a pitch energy storage unit 128 or of the energy storage device(s) 130 contained therein is obtained. Note that the SoH may be obtained by the method described above, or any other suitable means of providing a good estimate of a SoH, including modelling physical properties of its internal components, based on other data, including monitored environment conditions and usage periods.

In the described embodiment, the state of health of a capacitor-based pitch energy storage unit 128 may be represented by the equivalent capacity C and the equivalent series resistance $R_i$ of the equivalent circuit 140 shown in Figure 3. In this case, e.g., if the capacity C and/or the internal resistance $R_i$ of the capacitor is known during operation, the charging voltage can be varied during the lifetime in order to always select the lowest possible charging voltage with which a desired load profile is still fulfilled. A load profile may indicate a predetermined amount of electrical power and/or energy required to control the wind turbine 100 in an emergency situation. For example, it may indicate the amount of electrical power required to brake the rotor 108 to a standstill.

Accordingly, in step 304, a determination is performed to establish whether the SoH of the pitch energy storage unit 128 meets at least one health criterion or not. Note that the health criterion may take the form of a single numerical threshold, such as an estimated SoC value indicated as a percentage. Alternatively, step 304 may include a number of individual determinations, such as validating a combination of individual parameters, obtained, for example, during estimation.

In the specific example, the equivalent capacity C and the equivalent series resistance $R_i$ taken from the ECM 140 are compared with corresponding parameter values indicative for the equivalent capacity $C$ and the equivalent series resistance $R_i$ at the end of their service life.

In step 306, a first charging method based on a first charging parameter is used to charge the pitch energy storage unit 128 if the pitch energy storage unit 128 meets the at least one health criterion. The at least one health criterion may indicate that the pitch energy storage unit 128 is close to its beginning of life (BoL), or at least closer than to its end of life (EoL).

In the described implementation, a first charging voltage, for example 430V, is used to charge the pitch energy storage unit 128 in a service period towards the BoL.

Note that in case of a capacitor-based pitch energy storage unit 128, the pitch energy storage unit 128 is typically charged with a constant current until a desired target voltage is measured at the two terminals 132 and 134. Thereafter, the desired target voltage is maintained, but the charging voltage drops to essentially zero.

If pitch energy storage unit 128 does not meet at least one of the health criteria, in step 308, a second charging method based on a second charging parameter is used to charge the pitch energy storage unit 128. Failing the at least one health criterion may indicate that the pitch energy storage unit 128 is close to its end of life (EoL), or at least closer than to its beginning of life (BoL).

In the described implementation, when the equivalent capacity C decreases and/or the series resistance $R_i$ rises over a respective threshold value throughout the lifetime of the pitch energy storage unit 128, the charging voltage is increased. For example, at or near the EoL, a second charging voltage, for example 460V, is used.

Note that in the disclosed implementation, the charging voltage is increased linearly from the BoL to the EoL value. Specifically, as the energy stored in a capacitor is proportional to both its voltage and capacity, the charging voltage is increased in an anti-proportional fashion with respect to a decrease in the equivalent capacity C, such that the amount of energy stored in the fully charged pitch energy storage unit 128 remains essentially constant over its lifetime.

Alternatively, only two distinct charging parameter values, e.g. charging voltages of either 430 or 460 V, may be used in two corresponding parts of the overall life cycle. In general, any number of charging parameter values may be used for a corresponding number of the overall life cycle, e.g. charging voltages of 430, 440, 450 or 460 V.

Attention is drawn to the fact that, due to the higher capacity near the BoL, the amount of energy stored in the pitch energy storage unit 128 in the first part of its service life is still sufficient for emergency operation at the lower charging voltage. At the same time, the use of the lower charging voltage reduces the stress on the capacitors contained therein, thus extending the service life of the pitch energy storage unit 128.

At least in case of capacitors being used as storage elements, the capacity C and resistance $R_i$ normally depend on the temperature of the pitch energy storage unit 128. Usually, the capacity 312 and resistance 314 of a capacitor are slightly better at higher temperatures, as shown in Figure 8. Moreover, at higher temperatures the internal storage devices 130 forming the individual storage cells of the pitch energy storage unit 128 age faster.

Note that the above methods 150 and 170 for estimating the health status of the pitch energy storage unit 128 disclosed above determines a more or less instantaneous value for the equivalent capacity C and the series resistance $R_i$. Thus, the adaptive charging method 300 will automatically select a lower charging voltage at higher temperatures (due to the higher capacity and lower resistance obtained from the estimator) and thereby at least partly compensate for the faster aging due the higher temperature. Note that at least in case the capacity $C$ and resistance $Ri$ are obtained from the estimator as detailed above, no knowledge of the actual age, charging and operating history, or temperature is needed to select an appropriate charging voltage.

In the case that the pitch energy storage unit 128 comprises at least one rechargeable battery cell for pitch energy storage, charging the pitch energy storage unit 128 typically comprises charging the rechargeable battery cell using a battery charging circuit or management system, which may be adapted to the type of the battery being used, e.g. a lithium battery. The battery charging circuit usually switches off a charging voltage, when a target voltage is reached, and may repeatedly perform short loading cycles to maintain a desired charging level as requested by the battery charging circuit or management system. In this case, a charging current, duration or frequency of the battery charging circuit or management system may be updated based on the determined state of health.

Reference signs

| 100 | wind turbine |
| 102 | tower |
| 104 | foundation |

106     nacelle
108     rotor
110     rotor blade
112     rotor hub

120     pitch control system
122     pitch drive
124     pitch controller
126     pitch converter
128     pitch energy storage unit
130     energy storage device
132     (first) terminal
134     (second) terminal

140     equivalent circuit model (ECM)
142     (measurement) node
144     (reference) node
146     (equivalent) capacitor
148     (equivalent) series resistor
149     (equivalent) parallel resistor

150          method
152 - 166    method steps

170          method
172 - 196    method steps

202     first graph
204     second graph
206     first phase
208     second phase
210     third phase
212     fourth phase
214     fifth phase
216     sixth phase

222     third graph
224     fourth graph
226     fifth graph

232     sixth graph
234     seventh graph
236     eighth graph

240     first order ECM
250     $n^{th}$ order ECM

300          method
302 - 308    method steps

$u$     voltage
$i_m$   measured current
$i_s$   calculated current

$C$     (equivalent) capacitance
$R_i$   (equivalent) series resistance
$R_p$   (equivalent) parallel resistance

**Claims**

1.  A method (150) for estimating a health status of a pitch energy storage unit (128) of a wind turbine (100), the method (150) comprising:

    - providing (152) an equivalent circuit model (140), ECM, of the pitch energy storage unit (128), the ECM (140) comprising at least an equivalent series resistor (148) and at least one electrical energy storage element connected between two power terminals (132, 134);
    - repeatedly sampling (156, 158) a voltage u and a corresponding current $i_m$ at the two power terminals (132, 134);
    - determining (160, 162) at least one voltage change and at least one current change for a plurality of voltage samples and corresponding current samples;
    - performing (164) an optimisation procedure based at least on the ECM (140), the plurality of the voltage samples, the plurality of the current samples, the determined voltage changes, and the determined current changes to obtain an updated resistance $R_i$ of the equivalent series resistor (148) and updated at least one model parameter of the at least one electrical energy storage element; and
    - estimating (166) at least one status of health parameter for the pitch energy storage unit (128) by comparing at least one of the updated resistance $R_i$ and the updated at least one model parameter with at least one threshold value.

2.  The method (150) of claim 1, wherein:

    - the optimisation procedure is based on a predetermined number of sample tuples $(x_1, x_2, x_3, i_m)$, each sample tuple $(x_1, x_2, x_3, i_m)$ comprising a present voltage sample $(u=x_3)$, a corresponding time derivative $(x_1=du/dt)$ of the voltage $u$, a present current sample $i_m$, and a corresponding time derivative $(x_2=di_m/dt)$ of the current $i_m$; and
    - the optimisation procedure is performed when a predetermined number of sample tuples $(x_1, x_2, x_3, i_m)$ has been stored in a buffer storage.

3.  The method (150) of claim 2, further comprising:

    - determining whether a present sample tuple meets at least one predetermined filter criterion, in particular, if the present sample tuple $(x_1, x_2, x_3, i_m)$ differs from all sample tuples contained in the buffer storage; and
    - if the at least one predetermined filter criterion is met, adding the present sample tuple $(x_1, x_2, x_3, i_m)$ to the buffer storage, otherwise, discarding the present sample tuple $(x_1, x_2, x_3, i_m)$.

4.  The method (150) of any one of claims 1 to 3, wherein the optimization procedure is performed multiple times, and the method (150) further comprises:

    - selecting (154, 184) starting values for a set of optimization parameters optimized by the optimization procedure;
    - determining (188) at least one quality parameter $RSS_{new}$ associated with updated values of the set of optimization parameters obtained after performing the optimisation procedure starting from the starting values; and
    - if the at least one quality parameter $RSS_{new}$ associated with the set of optimization parameters meets at least one quality condition, computing (192) the updated resistance of the equivalent series resistor (148) and the updated at least one model parameter of the at least one electrical energy storage element, and otherwise maintaining a previously computed resistance of the equivalent series resistor (148) and at least one model parameter of the at least one electrical energy storage element.

5.  The method (150) of claim 4, wherein selecting the starting values for the set of optimization parameters comprises at least one of the following:

    - selecting a set of predefined initial starting values, in particular for performing the optimization procedure for the first time or after performing the optimisation procedure for a predetermined number of times; or
    - selecting the updated values obtained at a previous time when the optimization procedure was performed.

6.  The method (150) of claim 4 or 5, wherein

    - each time the optimization procedure is performed, a residual sum of squares, RSS, is computed as $RSS = \|A a - I_m\|^2$, wherein $A$ corresponds to a matrix of sample values comprising the plurality of voltage samples $(x_3=u)$ and

the corresponding time derivative of the voltage ($x_1 = du/dt$) and the corresponding derivative of the current ($x_2 = di/dt$), **a** corresponds to a vector of the optimisation parameters, and $\boldsymbol{I_m}$ corresponds to a vector of sampled currents;
- the at least one quality parameter $RSS_{new}$ corresponds to the RSS; and
- the at least one quality condition comprises determining whether the computed RSS is smaller than an RSS computed in a previous repetition of the optimisation procedure.

7. The method (150) of claim 6, wherein

- the optimisation procedure is performed using a gradient optimizer,
- the gradient optimizer performs up to $k_{max}$ optimisation steps, with $k_{max} \geq 1$;
- the gradient optimizer minimizes the RSS.

8. The method (150) of any one of claims 1 to 7, wherein the step of estimating (166) the health status of the pitch energy storage unit (128) comprises at least one of the following:

- comparing the updated at least one model parameter of the at least one electrical energy storage element with a nominal parameter value of the at least one electrical energy storage element, in particular, with a predetermined multiple of the nominal parameter value; and
- comparing the updated resistance $R_i$ with a nominal resistance value of the equivalent series resistor (148), in particular, with a predetermined multiple of the nominal resistance.

9. The method of any one of claims 1 to 8, further comprising:

- requesting at least one of a controlled charging or discharging event of the pitch energy storage unit, in particular using a predetermined charging or discharging current; and
- sampling (156, 158) the voltage u and the corresponding current $i_m$ at the two power terminals (132, 134) at least once during the controlled charging or discharging event.

10. The method (150) of any one of claims 1 to 9, wherein the pitch energy storage unit (128) comprises at least one capacitor, in particular an ultra-capacitor, for pitch energy storage, the at least one energy storage element of the ECM (140) comprises an equivalent capacitor (146) and the updated parameter corresponds to an updated capacitance C of the equivalent capacitor (146).

11. The method (150) claim 10, wherein the ECM (146) further comprises an equivalent parallel resistor (149) with a resistance $R_p$ connected in parallel with the equivalent capacitor (146), wherein a total modelled current $i_s$ in the ECM (140) is defined by the following equation:

$$i_s := C/(1 + R_i/R_p)\, du/dt - CR_i(1 + R_i/R_p)\, di_m/dt + 1/(R_p + R_i)\, u .$$

12. The method (150) of claim 10 or 11, further comprising:

- if the health status indicates that the pitch energy storage unit is at or near its begin-of-life, BoL, then charging the capacitor to a first charging voltage sufficient to provide a predetermined amount of electrical power and/or energy; and
- if the health status indicates that the pitch energy storage unit is at or near its end-of-life, EoL, charging the capacitor to a second charging voltage sufficient to provide the predetermined amount of electrical power and/or energy, wherein the second charging voltage exceeds the first charging voltage.

13. The method (150) of claim 12, wherein the health status indicates an estimated capacitance C of the capacitor, and a charging voltage for the capacitor is increased from the first charging voltage to the second charging voltage based on the estimated capacitance C, in particular in an anti-proportional ratio.

14. The method (150) of any one of claims 1 to 9, wherein the pitch energy storage unit (128) comprises at least one rechargeable battery cell for pitch energy storage, the at least one energy storage element of the ECM comprises an equivalent voltage source, and the updated parameter corresponds to a voltage of the equivalent voltage source.

15. A pitch control system (120) for a wind turbine (100), the wind turbine (100) comprising an energy storage unit and a converter circuit, in particular a pitch energy storage unit (128) and a pitch converter (126), wherein:

- the energy storage unit comprises at least one energy storage device (130), and has at least two power terminals (132, 134) for receiving or providing electrical energy;
- the converter circuit is connected via the at least two power terminals (132, 134) to the energy storage unit to selectively charge or discharge the at least one storage device (130) of the energy storage unit; and
- the pitch control system (120) further comprises at least one controller, in particular a controller (124) of the converter circuit, the at least one controller (124) being configured to implement a method according to any one of claims 1 to 14.

Fig. 1

Fig. 2

120

132

128 Pitch energy storage unit

$i_m$

u

130 Energy storage device

...

130 Energy storage device

134

126 Pitch converter

124 controller

122 Pitch drive

Fig. 3A

140

$i_s$

142

148

Ri

u

u_C

i_C

146

C

149

i_p

Rp

144

Fig. 3B

Fig. 3C

Fig. 4

150

152

154

156

158

160

162

164

166

Fig. 5

172 — Start of Cycle

170

174 — Measure Energy Storage Voltage and Current

176 — Rate, Condition Measurement and Check List of Samples

178 — Sample List full? — No → 180 — Add Sample to List

Yes

182 — Remove oldes Sample from List, Add new Sample to List

184 — Choose Starting Point for Optimizer

186 — Optimizer: Tune Storage Parameters

188 — Rate quality of new Parameter Estimation

190 — New Estimation better than last? — No → 194 — Reject new Estimated Parameters

Yes

192 — Take over new Estimated Parameters

196 — End of Cycle

Fig. 6

Fig. 7

300

Fig. 8

Europäisches
Patentamt

European
Patent Office

Office européen
des brevets

# EUROPEAN SEARCH REPORT

Application Number

EP 23 18 0031

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 2 578 876 A1 (SIEMENS AG [DE]) 10 April 2013 (2013-04-10) * paragraph [0004] * * paragraph [0012] - paragraph [0017]; figures 1,2 * | 1-15 | INV. F03D17/00 F03D80/00 |
| Y | GB 2 532 726 A (ANDRE THUNOT [GB]; PAUL ROBERTSON [GB]) 1 June 2016 (2016-06-01) * abstract; figures 1,2 * * paragraph [0001] * * paragraph [0008] * * paragraph [0011] * * paragraph [0034] - paragraph [0035] * * paragraph [0042] - paragraph [0046] * * paragraph [0060] * | 1-15 | |
| A | EP 3 543 523 A1 (GEN ELECTRIC [US]) 25 September 2019 (2019-09-25) * abstract * * paragraph [0010] * * paragraph [0018] * * paragraph [0023] * * paragraph [0033] - paragraph [0037]; figures 4,5 * | 1-15 | |
| A | DE 10 2008 025944 A1 (REPOWER SYSTEMS AG [DE]) 3 December 2009 (2009-12-03) * abstract * * paragraph [0007] - paragraph [0009] * * paragraph [0018] * * paragraph [0032] - paragraph [0032] * * paragraph [0037] * * paragraph [0047] - paragraph [0050]; figures 2-5 * | 1-15 | |

TECHNICAL FIELDS SEARCHED (IPC)

F03D
G05B

-/--

The present search report has been drawn up for all claims

| Place of search | Date of completion of the search | Examiner |
|---|---|---|
| The Hague | 11 December 2023 | Westermayer, Philipp |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
................................................................
& : member of the same patent family, corresponding
document

EPO FORM 1503 03.82 (P04C01)

page 1 of 2

Europäisches
Patentamt
European
Patent Office
Office européen
des brevets

# EUROPEAN SEARCH REPORT

Application Number

EP 23 18 0031

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | DE 10 2019 127384 A1 (BAYERISCHE MOTOREN WERKE AG [DE]) 15 April 2021 (2021-04-15) <br> * abstract * <br> * paragraph [0006] – paragraph [0009] * <br> * paragraph [0015]; figures 1-3 * <br> ————— | 1-15 | |

| | | | TECHNICAL FIELDS SEARCHED (IPC) |
|---|---|---|---|

The present search report has been drawn up for all claims

| Place of search | Date of completion of the search | Examiner |
|---|---|---|
| The Hague | 11 December 2023 | Westermayer, Philipp |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

    ..............................................................................................

& : member of the same patent family, corresponding
    document

EPO FORM 1503 03.82 (P04C01)

page 2 of 2

EP 4 481 195 A1

## ANNEX TO THE EUROPEAN SEARCH REPORT
## ON EUROPEAN PATENT APPLICATION NO.

EP 23 18 0031

This annex lists the patent family members relating to the patent documents cited in  the above-mentioned European search report.
The members are as contained in the European Patent Office EDP file on
The European Patent Office is in no way liable for these particulars which are merely given for the purpose of information.

11-12-2023

| Patent document cited in search report | | Publication date | Patent family member(s) | | Publication date |
|---|---|---|---|---|---|
| EP 2578876 | A1 | 10-04-2013 | CN | 103032264 A | 10-04-2013 |
| | | | DK | 2578876 T3 | 25-08-2014 |
| | | | EP | 2578876 A1 | 10-04-2013 |
| | | | US | 2013088010 A1 | 11-04-2013 |
| GB 2532726 | A | 01-06-2016 | NONE | | |
| EP 3543523 | A1 | 25-09-2019 | EP | 3543523 A1 | 25-09-2019 |
| | | | US | 2019285058 A1 | 19-09-2019 |
| DE 102008025944 | A1 | 03-12-2009 | CA | 2725870 A1 | 10-12-2009 |
| | | | CN | 102105807 A | 22-06-2011 |
| | | | DE | 102008025944 A1 | 03-12-2009 |
| | | | DK | 2313792 T3 | 31-07-2017 |
| | | | EP | 2313792 A2 | 27-04-2011 |
| | | | ES | 2628177 T3 | 02-08-2017 |
| | | | US | 2011181045 A1 | 28-07-2011 |
| | | | WO | 2009146848 A2 | 10-12-2009 |
| DE 102019127384 | A1 | 15-04-2021 | CN | 114502970 A | 13-05-2022 |
| | | | DE | 102019127384 A1 | 15-04-2021 |
| | | | WO | 2021069232 A1 | 15-04-2021 |

EPO FORM P0459

For more details about this annex : see Official Journal of the European Patent Office, No. 12/82

26